(19) Europäisches Patentamt
European Patent Office
Office européen des brevets

(11) **EP 4 391 735 A1**

(12) **EUROPEAN PATENT APPLICATION**

(43) Date of publication:
**26.06.2024 Bulletin 2024/26**

(21) Application number: **23193487.8**

(22) Date of filing: **25.08.2023**

(51) International Patent Classification (IPC):
**H05K 1/03** (2006.01)     **H05K 3/02** (2006.01)
**B32B 15/08** (2006.01)     **H05K 1/09** (2006.01)
**B21B 1/40** (2006.01)

(52) Cooperative Patent Classification (CPC):
**H05K 1/0393; H05K 1/09; H05K 3/022;**
**H05K 3/384;** B32B 15/08

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **21.12.2022   JP 2022204740**
**22.12.2022   JP 2022205900**

(71) Applicant: **JX Metals Corporation**
**Tokyo 105-8417 (JP)**

(72) Inventors:
• ISHINO, Yuji
**Hitachi-shi, 3170056 (JP)**
• IKEDA, Takao
**Kouza-gun, 253-0101 (JP)**
• KUSUNOKI, Keisuke
**Hitachi-shi, 3170056 (JP)**

(74) Representative: **Mewburn Ellis LLP**
**Aurora Building**
**Counterslip**
**Bristol BS1 6BX (GB)**

(54) **COPPER FOIL, LAMINATE, AND FLEXIBLE PRINTED WIRING BOARD**

(57)     A copper foil, wherein at least one surface of the copper foil has a root mean square gradient (Sdq) of 0.120 or less.

**Description**

**FIELD OF THE INVENTION**

The present invention relates to a copper foil, a laminate, and a flexible printed wiring board. In particular, the present invention relates to a copper foil having excellent transmission characteristics as a copper foil for high frequency circuits, and a laminate and a flexible printed wiring board provided with such a copper foil.

**BACKGROUND OF THE INVENTION**

Printed wiring boards have made great progress over the last half century, and are now used in almost all electronic devices. In recent years, with the increasing needs for miniaturization and high performance of electronic devices, high-density mounting of mounted parts and signals with higher frequency are progressing, and there is a demand for printed wiring boards that can cope with high frequencies.

High frequency circuit boards are required to reduce conduction loss in order to ensure the quality of output signals. Conduction loss mainly consists of dielectric loss caused by the resin (substrate side) and conductor loss caused by the conductor (copper foil side). Dielectric loss decreases as the dielectric constant and dielectric loss tangent of the resin decrease. In high frequency signals, the main cause of conductor loss is that the cross-sectional area through which current flows decreases due to the skin effect, that is, the higher the frequency is, the more current flows only on the surface of the conductor, and the resistance increases.

As a technique for reducing the conduction loss of a copper foil for high frequency circuits, for example, Patent Literature 1 (Japanese Patent No. 4161304) discloses a metal foil for high frequency circuits, in which one or both surfaces of the metal foil surface is coated with silver or a silver alloy, and a coating layer other than the silver or the silver alloy is coated on the silver or the silver alloy coating layer to a thickness thinner than the thickness of the silver or the silver alloy coating layer. Further, according to this literature, it is possible to provide a metal foil that reduces loss due to the skin effect even in the ultra-high frequency range used in satellite communications.

In addition, Patent Literature 2 (Japanese Patent No. 4704025) discloses a roughening treated rolled copper foil for high frequency circuits characterized in that, a ratio of an integrated intensity ($I_{(200)}$) of a (200) plane determined by X-ray diffraction on the rolled surface after recrystallization annealing of the rolled copper foil to an Integrated intensity ($I_{0(200)}$) of a (200) plane determined by X-ray diffraction of fine copper powder is $I_{(200)} / I_{0(200)} > 40$, and an arithmetic mean roughness (hereinafter referred to as Ra) of a roughened surface after a roughening treatment by electrolytic plating on the rolled surface is 0.02 $\mu$m to 0.2 $\mu$m, and a ten-point average roughness (hereinafter referred to as Rz) is 0.1 $\mu$m to 1.5 $\mu$m, and it is a material for printed circuit boards. Further, according to this literature, it is possible to provide a printed circuit board that can be used at high frequencies exceeding 1 GHz.

In addition, Patent Literature 3 (Japanese Patent Application Publication No. 2004-244656) discloses an electrolytic copper foil, characterized in that part of the surface of the copper foil is an uneven surface with a surface roughness of 2 $\mu$m to 4 $\mu$m consisting of hump-like protrusions. Further, according to this literature, it is described that an electrolytic copper foil excellent in high frequency transmission characteristics can be provided.

Furthermore, Patent Literature 4 (Japanese Patent Application Publication No. 2017-193778) discloses a copper foil having a roughened layer, wherein the roughened layer has a primary particle layer, a surface roughness Ra of the primary particle layer side surface is 0.12 $\mu$m or less, and an average particle size of the primary particles of the primary particle layer is 0.10 to 0.25 $\mu$m. It is described that, by forming such a predetermined roughened particle layer and controlling the surface roughness Ra of the roughened particle layer side surface and the average particle diameter of the roughened particles, it is effective in suppressing conduction loss when used in high frequency circuit boards.

**PRIOR ART**

Patent Literature

[Patent Literature 1] Japanese Patent No. 4161304

[Patent Literature 2] Japanese Patent No. 4704025

[Patent Literature 3] Japanese Patent Application Publication No. 2004-244656

[Patent Literature 4] Japanese Patent Application Publication No. 2017-193778

## SUMMARY OF THE INVENTION

In recent years, with the further progress of higher frequency signals, there is a growing need for manufacturing printed wiring boards with superior transmission characteristics in a high frequency range such as 10 GHz or higher, and further improvement of copper foil, which is the raw material, is required. In particular, the higher the frequency of the signal is, the lower the conductivity of the copper foil becomes due to the skin effect, which becomes a factor in worsening the conduction loss. However, with the techniques described in Patent Literatures 1 to 4, it can be difficult to cope with high frequency circuit boards of 10 GHz or higher. In particular, the invention according to Patent Literatures 4 focuses on the fact that the roughness of the copper foil surface is the main factor of conductor loss, and that the smaller the roughness is, the lower the conduction loss is. The are excellent inventions in that both suppression of conduction loss and adhesion to a resin can be achieved by controlling the surface roughness Ra of the roughened particle layer side surface and the average particle size of the roughened particles. However, there is also the problem that the conditions for roughening treatment must be strictly controlled. In addition, the presence of roughening particles inevitably increases the resistance due to the skin effect as described above.

The present invention has been completed in view of the above problems, and in one embodiment, an object of the present invention is to provide a copper foil with little conduction loss as a copper foil for high frequency circuits. Further, in another embodiment, another object of the present invention is to provide a laminate and a flexible printed wiring board provided with such a copper foil.

As a result of intensive studies, the inventors of the present invention found that it is effective to control the root mean square gradient (Sdq) of the copper foil surface before a surface treatment as a characteristic of the copper foil for suppressing the above-mentioned skin effect and suppressing the conduction loss in high frequency transmission. In particular, it has been found that, when applying a surface treatment to the surface of the copper foil that is expected to have increased conductor loss, by controlling the Sdq of the copper foil to an appropriate range before a surface treatment, it is possible to suppress the increase in conduction loss in high frequency transmission while enjoying the benefits of the surface treatment even if a surface treatment containing a magnetic metal is applied. The present invention has been completed based on the above findings, and is exemplified as below.

[1] A copper foil, wherein at least one surface of the copper foil has a root mean square gradient (Sdq) of 0.120 or less.

[2] The copper foil according to [1], wherein the at least one surface of the copper foil has the root mean square gradient (Sdq) of 0.100 or less.

[3] The copper foil according to [1] or [2], further comprising a surface treatment layer on the at least one surface.

[4] The copper foil according to any one of [1] to [3], wherein the copper foil is a rolled copper foil.

[5] A laminate, comprising the copper foil according to any one of [1] to [4]; and a resin substrate.

[6] A flexible printed wiring board provided with the laminate according to [5].

According to one embodiment of the present invention, it is possible to provide a copper foil with little conduction loss as a copper foil for high frequency circuits. Furthermore, according to another embodiment of the present invention, it is possible to provide a laminate and a flexible printed wiring board provided with such a copper foil.

## BRIEF DESCRIPTION OF THE DRAWINGS

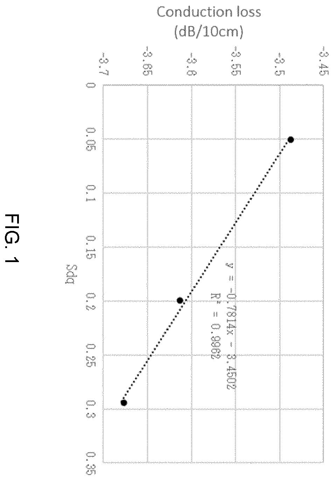

FIG. 1 is a graph in which the root mean square gradient (Sdq) is plotted on the horizontal axis and the conduction loss is plotted on the vertical axis, based on the Example and the Comparative Examples.

## DETAILED DESCRIPTION OF THE INVENTION

Hereinafter, embodiments of the present invention will now be described in detail. It should be understood that the present invention is not intended to be limited to the following embodiments, and any change, improvement or the like of the design may be appropriately added based on ordinary knowledge of those skilled in the art without departing from the spirit of the present invention.

(Composition of copper foil)

There is no particular limitation on the form of the copper foil that can be used in this embodiment. In addition, typically, the copper foil used in the present invention may be either an electrolytic copper foil or a rolled copper foil. In general, an electrolytic copper foil is manufactured by electrolytically depositing copper from a copper sulfate plating bath onto a titanium or stainless steel drum, and a rolled copper foil is manufactured by repeating plastic working and heat treatment using rolling rolls. Rolled copper foil is often used for applications that require flexibility.

As the copper foil material, in addition to high-purity copper such as tough pitch copper and oxygen-free copper, which are usually used as conductor patterns of printed wiring boards, for example, copper containing Sn, copper containing Ag, copper alloys such as copper alloys with added P, Cr, Zr, Mg, and the like, and Corson copper alloys with added Ni, Si, and the like can also be used. In this specification, when the term "copper foil" is used alone, it also includes copper alloy foil.

In addition, the thickness of the copper foil is not particularly limited, but for example, it may be 1 to 1000 $\mu$m, or 1 to 500 $\mu$m, or 1 to 300 $\mu$m, or 3 to 100 $\mu$m, or 5 to 70 $\mu$m, or 6 to 35 $\mu$m, or 9 to 18 $\mu$m.

The copper foil of this embodiment can be suitably used for high frequency circuit applications. Here, the high frequency circuit means a circuit in which the signal frequency transmitted through the circuit is 10 GHz or higher.

In the present embodiment, at least one surface of the copper foil has a root mean square gradient (Sdq) of 0.120 or less. The root mean square gradient is a parameter calculated by the root mean square of the gradients at all points in a defined area, and the Sdq of a completely flat surface without unevenness is 0. If the surface has unevenness, Sdq is greater than 0 because of the gradients of the surface. In addition, Sdq tends to increase as local gradient angles increase. Therefore, Sdq is an index that quantifies the steepness of surface unevenness (steepness of gradients). As Sdq increases, conduction loss at high frequencies increases due to the aforementioned skin effect, so Sdq is preferably small. In particular, when a copper foil is subjected to a surface treatment, the surface profile tends to increase significantly due to the adhesion of a metal of the surface treatment layer to steep surface unevenness, and from this point of view, a copper foil with a gentle surface unevenness is desirable.

From the above viewpoints, the root mean square gradient (Sdq) is preferably 0.100 or less, more preferably 0.060 or less. The lower limit of Sdq is not limited from the viewpoint of conduction loss, but it is assumed there are some cases where scratches on the copper foil surface become conspicuous, so it is desirable to be 0.001 or more, more preferably 0.002 or more.

As more typical indicators of surface roughness, arithmetic mean height (Sa) and maximum height (Sz) can be mentioned, but it is considered that they are not suitable for representing the degree of increase in transmission distance when a signal flows only near the surface of the copper foil due to the skin effect. This is because it is considered that the maximum height (Sz) is an index whose value fluctuates greatly due to particular points such as scratches scattered on the copper foil surface, and it is inappropriate as an indicator of characteristics as a high frequency circuit when signals flows over the entire copper foil surface. Further, the arithmetic mean height (Sa) is considered inappropriate because there is concern that fine undulations that contribute to an increase in transmission distance may be ignored due to larger undulations. Therefore, it is considered that the root mean square gradient (Sdq), which directly represents the degree of increase in transmission distance when a signal flows only near the surface of the copper foil due to the skin effect, is a suitable index that represents the essential properties.

As described later, the root mean square gradient (Sdq) is calculated upon a measurement of the roughness data of a copper foil surface with a Keyence laser microscope VK-X1000 (controller unit) / 1050 (head unit) or an equivalent device, in accordance with ISO25178-2: 2012. In addition, as described above, the root mean square gradient (Sdq) is an important parameter from the viewpoint of suppressing the increase in conduction loss due to a surface treatment. Therefore, when a copper foil is surface treated, the root mean square gradient (Sdq) of the copper foil before the surface treatment is measured.

Moreover, at least one surface of the copper foil can be provided with a surface treatment layer. The surface treatment layer may be a roughening treatment layer. Roughening treatment is usually performed on the surface of the copper foil to be adhered to a resin substrate, that is, the surface on the surface treatment layer side, for the purpose of improving the peel strength of the copper foil after lamination. This refers to a process of forming bumpy electrodeposits on the surface of copper foil after degreasing. Although an electrolytic copper foil has unevenness at the time of production, the unevenness can be further enhanced by strengthening the convex portions of the electrolytic copper foil by roughening treatment. The roughening treatment can be performed, for example, by forming roughening particles with copper or a copper alloy. The roughening treatment may be performed for fine particles. The roughened layer may be a layer consisting of any one selected from the group consisting of copper, nickel, cobalt, phosphorus, tungsten, arsenic, molybdenum, chromium and zinc, and the like, or a layer consisting of an alloying containing one or more selected from the above group. Moreover, after forming roughening particles with copper or a copper alloy, it is also possible to carry out a further roughening treatment in which secondary particles or tertiary particles are provided with nickel, cobalt, copper, zinc as a single substance or an alloy, or the like.

Further, the surface treatment layer may be one or more layers selected from the group consisting of a heat-resistant layer, an antirust layer, a chromate treatment layer and a silane coupling treatment layer, in addition to the roughening treatment layer. These layers can be provided using a known technique. In addition, as described later, the copper foil of the present invention can be controlled for the above-mentioned root mean square gradient (Sdq) without any surface treatment, so in one embodiment, the copper foil does not comprise a surface treatment layer in the sense that the manufacturing method can be simple.

From the viewpoint of corrosion resistance and heat resistance, the surface treatment layer preferably contains a magnetic metal such as nickel or cobalt. The skin depth during high frequency signal transmission is expressed by the following formula. As the magnetic permeability ($\mu$) increases, the skin depth decreases and the skin effect due to the increase in the surface profile appears more remarkably, so the effect of the present invention also appears more remarkably. Magnetic permeability increases with magnetic metals, so when a surface treatment containing a magnetic metal as one component is applied, the difference in conduction loss at high frequencies between the copper foil of the present invention and conventional copper foils becomes even more significant.

$$\text{Surface depth} \quad \delta = \frac{1}{\sqrt{\pi \cdot f \cdot \mu \cdot \sigma}} \quad [\mu m]$$

(in which, f is frequency, $\mu$ is permeability, and $\sigma$ is conductivity.)

A laminate can be manufactured by bonding the copper foil of the present invention to a resin substrate. The resin substrate is not particularly limited as long as it has properties applicable to printed wiring boards or the like. However, for example, a polyester film such as polyethylene terephthalate (PET), a polyimide film, a liquid crystal polymer (LCP) film, a fluororesin film, or the like can be used.

The method of lamination can be laminating and adhering a rolled copper foil to a substrate such as a polyimide film via an adhesive or under high temperature and high pressure without using an adhesive, or by coating, drying, curing, and the like of a polyimide precursor to manufacture a laminate.

Also, the laminate can be used to construct a printed wiring board, particularly a flexible printed wiring board. Therefore, in another aspect, the present invention discloses a method for manufacture a printed wiring board, particularly a flexible printed wiring board, using the rolled copper foil of the present invention and the laminate of the present invention.

(Manufacture method)

The method for manufacturing the copper foil of the present invention is not particularly limited as long as the above-mentioned root mean square gradient (Sdq) can be controlled within the scope of the present invention. However, as a manufacture method that can be easily carried out without surface treatment, a method of appropriately adjusting the oil film thickness equivalent of a final rolling pass in a final cold rolling step can be adopted.

In the present embodiment, as a method for manufacturing the rolled copper foil, first, raw materials are melted in a melting furnace to obtain molten metal having a desired composition. Then, this molten metal is cast into an ingot. Thereafter, hot rolling, cold rolling, and annealing are performed as appropriate to finish a foil having a predetermined thickness. After the heat treatment, the surface may be pickled, polished, or the like in order to remove the surface oxide film generated during the heat treatment. In the final cold rolling, the material after the heat treatment is repeatedly passed through a rolling mill to finish it to a predetermined thickness. In the method for manufacturing a rolled copper foil of the present embodiment, it is important to perform the final rolling pass with an oil film thickness equivalent of 10,000 to 40,000 in the final rolling pass of the final cold rolling step.

By controlling the oil film thickness equivalent, the developed interfacial area ratio of the copper foil surface can be suppressed. If the oil film thickness equivalent exceeds 40,000, the effect of flattening the surface of the copper foil becomes weak, and the reduction in the root mean square gradient (Sdq) becomes insufficient. On the other hand, if the oil film thickness equivalent is less than 10,000, the oil film between the copper foil and the rolling rolls becomes thin, so scratches and dirt on the surface of the rolling rolls are easily transferred to the copper foil surface, and the developed interfacial area ratio may increase.

Here, the oil film thickness equivalent is defined by the following formula.

$$\text{Oil film thickness equivalent} = \{(\text{rolling oil viscosity [cSt]}) \times (\text{entry side passing}$$

$$\text{speed [mm/s]} + \text{roll peripheral speed [mm/s]})\} / \{(\text{roll bite angle [rad]}) \times (\text{rolling}$$

$$\text{load per unit area [kg/mm}^2])\}$$

Rolling oil viscosity is measured according to JIS K2283. The entry side passing speed is calculated from the peripheral speed of the take-up reel on the exit side in consideration of the rolling work degree of the rolling pass. The roll peripheral speed is calculated from the peripheral speed of the take-up reel on the exit side, assuming that no slip occurred between the rolls and the material. Further, the roll bite angle and the rolling load per unit area are calculated using the following formulas. In addition, for the Young's modulus and Poisson's ratio of the roll, the values described in the roll manufacturer's catalog and the literature values of the roll material are used, respectively. The radius of the rolls is obtained by measuring the diameter with a roll diameter measuring machine capable of measuring in units of 0.0005 mm. The rolling load is calculated using the diameter and number of cylinders from the pressure measured by the hydraulic sensors of the hydraulic cylinders of the rolling mill. The reduction amount was calculated from the thickness of the material before and after passing. The material strip thickness can be measured, for example, according to the method for measuring mass thickness of JIS C6515.

$$\text{Roll bite angle} = \{(\text{reduction amount [mm]}) / (\text{flat radius of roll}$$

$$\text{[mm]})\}^{0.5}$$

$$\text{Rolling load per unit area} = (\text{rolling load [kg]}) / \{(\text{average strip width}$$

$$\text{[mm]}) \times (\text{contact arc length [mm]})\}$$

$$\text{Flat radius of roll} = (\text{radius of roll [mm]}) \times [1 + 16 \times \{1 - (\text{Poisson's}$$

$$\text{ratio of roll})^2\} / \{\pi \times (\text{Young's modulus of roll [kg/mm}^2])\} \times (\text{rolling load [kg]}) /$$

$$\{(\text{average strip width [mm]}) \times (\text{reduction amount [mm]})\}]$$

$$\text{Contact arc length} = \{(\text{reduction amount [mm]}) \times (\text{flat radius of roll}$$

$$\text{[mm]})\}^{0.5}$$

In addition, the numerical value of the oil film thickness equivalent in Table 1 is a numerical value rounded to the nearest 100.

In order to control the oil film thickness equivalent, known methods such as using low-viscosity rolling oil or slowing the entry side passing speed may be used.

**EXAMPLES**

Hereinafter, the present invention will be described in greater detail by way of Examples, but the descriptions here are for illustrative purposes only and are not intended to be limiting.

First, a copper ingot having the copper ratio shown in Table 1 was prepared and hot rolled. After performing hot rolling, cold rolling and annealing in an annealing furnace set at a temperature of 300 to 800 °C were performed for once or more, and then cold rolling was performed to obtain a rolled strip having a thickness of 0.1 to 1.0 mm. The rolled strip was annealed in an annealing furnace set at a temperature of 300 to 800 °C to recrystallize, and finally cold rolling was performed. The copper foil thickness of Example 1 was 12 μm, and the copper foil thickness of Comparative Examples 1 and 2 was 18 μm. At this time, in the final cold rolling step, the oil film thickness equivalent in the final rolling pass was changed as shown in Table 1 to manufactured the copper foils of the Example and the Comparative Examples.

Various evaluations were performed as follows for each sample of the Example and the Comparative Examples manufactured as described above. The results are shown in Table 1.

(Measurement of root mean square gradient (Sdq))

Shape measurement was performed using a laser microscope VK-X1000 (controller unit) / 1050 (head unit) manufactured by Keyence. After that, using the analysis software for the laser microscope VK-X1000 (controller unit)/1050 (head unit) manufactured by Keyence, the root mean square gradient (Sdq) was measured. At this time, an area of 250 μm × 200 μm (specifically, 50,000 μm$^2$) was measured at arbitrary 10 points using a 50× objective lens of the laser microscope, and the root mean square gradient (Sdq) at each point was calculated. For the 10 points, the arithmetic average value of the root mean square gradient (Sdq) obtained excluding the maximum value and the minimum value, that is, at 8 points, was taken as the value of the root mean square gradient (Sdq). In addition, in order to eliminate the influence of the tilt and undulation of the surface of the object to be measured when the object was subjected to the shape measurement, during the analysis using the analysis software, surface tilt correction and undulation removal (cutoff wavelength 0.08 mm) were performed as surface shape correction for the measurement area, and then the mean square gradient (Sdq) was calculated. In addition, the environmental temperature for measuring the mean square gradient (Sdq) with the laser microscope was 20 to 25 °C. The main setting conditions for the laser microscope and the analysis software are as follows.

<Measurement settings>

Measurement mode: easy measurement

Scan mode: laser confocal

Measurement size: standard (1024 × 768)

Measurement quality: high precision

Measurement pitch: 0.26 μm

RPD: ON

Brightness 1: approximately 6500 to 7500 (fluctuates due to fine focus adjustment)

Brightness 2: automatic (9500)

Lighting filter 1: Approximately 10 to 30% (fluctuates due to fine focus adjustment)

Lighting filter 2: automatic (approximately 10% to 30% (fluctuates due to fine focus adjustment))

Double scan: ON

Average number of times: 1 time

Do not acquire color images: OFF

Fine mode: ON

Enable noise area processing: OFF

<Lighting>

Coaxial incident light: 100

Ring certification: OFF

<Z-axis>

Z-axis mode: recommended settings

Measurement upper limit: about 9,900 to 10,100 $\mu$m (fluctuates due to fine focus adjustment)

Lower limit of measurement: about 10,000 to 10,100 $\mu$m (fluctuates due to fine focus adjustment)

Fixed Z measurement distance: OFF

Z measurement distance: about 13 to 14 $\mu$m (fluctuates due to fine focus adjustment)

Automatic upper and lower limits / automatic brightness: ON

<Head>

Head: R
Objective lens name: Plan (CF IC EPI Plan 50×)
Objective lens magnification: 50×
Lens NA: 0.800
WD: 0.54mm
Field curvature correction: ON
Light intensity eccentricity correction: ON
Ring illumination correction: ON
XY calibration: 268.846 nm/pixel
Z calibration: 1.000 (0.100 nm/digit)

<Camera settings>

Brightness mode: Auto

Brightness (auto): about 120-140 (fluctuates due to fine focus adjustment)

Brightness (manual): 2

Edge enhancement: 5

<Laser settings>

$\gamma$ coefficient ($\gamma$ correction value): 0.45

$\gamma$ offset: 0%

Black and white inversion: OFF

Edge enhancement type: None

Edge enhancement direction: horizontal

Edge enhancement strength: weak

<Other condition settings shown in the worksheet>

Measuring mode: surface shape
Optical zoom magnification: 1.0×
Filter: OFF
Camera gain: 0 dB
Shutter speed: Auto
White balance mode: manual
White balance R: 0
White balance B: 0
Received light amount correction mode: $\gamma$ correction
Head type: VK-X105
Vividness: 5
Contrast: 5
Brightness: 0
AI noise removal: OFF
Slope noise filter: OFF

<Analysis conditions>

Image processing: surface shape correction (surface tilt correction, undulation removal (cutoff wavelength 0.08 mm))

Surface roughness setting (filter setting)

Filter type: Gaussian

S-filter (low-pass filter): none

F-operation (shape correction): none

L-filter (high-pass filter): none

End effect correction: ON

(Measurement of conduction loss)

For the samples of each Example and Comparative Example, another sample prepared in the same process was subjected to Ni plating under the following conditions. Specifically, a sample with a width of 90 mm and a length of 210 mm was degreased using an aqueous solution of GN87 (manufactured by JX Metals Trading Co., Ltd.) and pickled with a 10% sulfuric acid aqueous solution. Next, Ni plating was carried out in a Watt bath (Ni 13 g/L, pH 2.3, temperature 50 °C) with a current density of 10 A/dm$^2$, and the plating time was adjusted so that the theoretical Ni deposition amount was 826 $\mu$g/dm$^2$. In addition, a copper clad laminate was prepared by laminating copper foils on both sides of a 50 $\mu$m PI (product name: UPILEX, manufactured by UBE Corporation) with a hot press so that the plated surface of the copper foils faced the PI side. A microstrip line was obtained by circuit processing (etching) such that the width of the copper foil on one side of the copper-clad laminate was about 110 $\mu$m. Using a network analyzer Keysight N5247A and a universal test fixture Anritsu Universal Test Fixture Model 3680V for converting the microstrip line and coaxial cables, the conduction loss of the microstrip line at a circuit frequency of 10 GHz was measured. The results are shown in Table 1.

Table 1

| | Copper ratio | Oil film thickness equivalent in final pass | Sdq | Conduction loss (db/10cm) |
| --- | --- | --- | --- | --- |
| | | | | 10GHz |
| Example 1 | No less than 99.96% | 28000 | 0.051 | -3.487 |
| Comparative Example 1 | No less than 99.96% | 58000 | 0.199 | -3.613 |
| Comparative Example 2 | No less than 99.96% | 500000 | 0.295 | -3.676 |

(Discussion)

In the Example, since the root mean square gradient (Sdq) on the surface was 0.120 or less, conduction loss at high frequencies was suppressed. On the other hand, in the Comparative Examples, since the oil film thickness equivalent of the final rolling pass in the final cold rolling was high, the root mean square gradient (Sdq) exceeded 0.120 and the conduction loss was larger than that of the Example. In addition, when the circuit frequency was changed to 20 GHz, 30 GHz, and 40 GHz, the conduction loss was measured under the above-mentioned conditions for each frequency, and it was found that the conduction loss was suppressed more in the Example than in the Comparative Examples.

Further, the result of plotting the root mean square gradient (Sdq) on the horizontal axis and the conduction loss on the vertical axis is shown in FIG. 1. In addition, the results of calculating an approximate straight line using the approximate straight line approximation function of Microsoft (registered trademark) Excel are shown in FIG. 1. The approximation formula of the straight line and the R-square value are also displayed. The closer the R-squared value is to 1, the better the fitted line represents the trend of the experimental data.

Based on the approximate straight line in FIG. 1, the conduction loss when the root mean square gradient (Sdq) is 0.100 and 0.120 is estimated as shown in Table 2, and it can be understood that the conduction loss is suppressed when the root mean square gradient (Sdq) is 0.100 and 0.120.

Table 2

| Sdq | Conduction loss (db/10cm) |
| --- | --- |
| | 10GHz |
| 0.100 | -3.528 |
| 0.120 | -3.544 |

**Claims**

1. A copper foil, wherein at least one surface of the copper foil has a root mean square gradient (Sdq) of 0.120 or less.

2. The copper foil according to claim 1, wherein the at least one surface of the copper foil has the root mean square gradient (Sdq) of 0.100 or less.

3. The copper foil according to claim 1 or 2, further comprising a surface treatment layer on the at least one surface.

4. The copper foil according to any one of claims 1 to 3, wherein the copper foil is a rolled copper foil.

5. A laminate, comprising the copper foil according to any one of claims 1 to 4; and a resin substrate.

6. A flexible printed wiring board provided with the laminate according to claim 5.

FIG. 1

Europäisches
Patentamt

European
Patent Office

Office européen
des brevets

# EUROPEAN SEARCH REPORT

Application Number

EP 23 19 3487

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/303405 A1 (FUKUCHI RYO [JP]) 19 October 2017 (2017-10-19) * paragraphs [0011], [0044], [0139], [0340], [0348]; claims 1-19 * | 1-6 | INV. H05K1/03 H05K3/02 B32B15/08 H05K1/09 |
| X | US 2016/212836 A1 (ARAI HIDETA [JP] ET AL) 21 July 2016 (2016-07-21) * paragraphs [0051], [0165], [0170], [0267], [0335]; claims 1-34 * | 1-6 | B21B1/40 |
| X | JP 2014 011451 A (JX NIPPON MINING & METALS CORP) 20 January 2014 (2014-01-20) * paragraphs [0002], [0011], [0022]; claims 1-7; table 1 * | 1-6 | |
| X | WO 2014/109396 A1 (JX NIPPON MINING & METALS CORP [JP]) 17 July 2014 (2014-07-17) * paragraph [0038]; claims 1-13 * | 1-6 | |
| X | US 2016/303829 A1 (ARAI HIDETA [JP] ET AL) 20 October 2016 (2016-10-20) * paragraphs [0184], [0232] – [0233], [0251], [0368]; claims 1-59; table 2 * * paragraphs [0182], [0251], [0233], [0306]; claims 1-59; table 2 * | 1-6 | TECHNICAL FIELDS SEARCHED (IPC) H05K B21B B32B |
| X | WO 2021/251288 A1 (MITSUI MINING & SMELTING CO LTD [JP]) 16 December 2021 (2021-12-16) * claims 1-12; table 1A * | 1-6 | |

The present search report has been drawn up for all claims

| Place of search | Date of completion of the search | Examiner |
|---|---|---|
| The Hague | 23 January 2024 | Pircher, Ernst |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 3487

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2024

| Patent document cited in search report | Publication date | Patent family member(s) | Publication date |
|---|---|---|---|
| US 2017303405 A1 | 19-10-2017 | CN 107302825 A | 27-10-2017 |
| | | EP 3232747 A1 | 18-10-2017 |
| | | JP 2017193778 A | 26-10-2017 |
| | | KR 20170118623 A | 25-10-2017 |
| | | PH 12017000133 A1 | 29-10-2018 |
| | | TW 201805487 A | 16-02-2018 |
| | | US 2017303405 A1 | 19-10-2017 |
| US 2016212836 A1 | 21-07-2016 | CN 105612274 A | 25-05-2016 |
| | | JP 6196985 B2 | 13-09-2017 |
| | | JP 6498089 B2 | 10-04-2019 |
| | | JP 2016029215 A | 03-03-2016 |
| | | JP WO2015030209 A1 | 02-03-2017 |
| | | KR 20160052528 A | 12-05-2016 |
| | | MY 176312 A | 28-07-2020 |
| | | PH 12016500404 A1 | 16-05-2016 |
| | | TW 201518078 A | 16-05-2015 |
| | | US 2016212836 A1 | 21-07-2016 |
| | | WO 2015030209 A1 | 05-03-2015 |
| JP 2014011451 A | 20-01-2014 | NONE | |
| WO 2014109396 A1 | 17-07-2014 | JP 5576514 B2 | 20-08-2014 |
| | | JP 2014133936 A | 24-07-2014 |
| | | TW 201438890 A | 16-10-2014 |
| | | WO 2014109396 A1 | 17-07-2014 |
| US 2016303829 A1 | 20-10-2016 | CN 105814242 A | 27-07-2016 |
| | | JP 5819569 B1 | 24-11-2015 |
| | | JP WO2015087941 A1 | 16-03-2017 |
| | | KR 20160086377 A | 19-07-2016 |
| | | MY 183425 A | 18-02-2021 |
| | | PH 12016501106 A1 | 11-07-2016 |
| | | TW 201531172 A | 01-08-2015 |
| | | US 2016303829 A1 | 20-10-2016 |
| | | WO 2015087941 A1 | 18-06-2015 |
| WO 2021251288 A1 | 16-12-2021 | CN 114514798 A | 17-05-2022 |
| | | CN 116367414 A | 30-06-2023 |
| | | JP 7053976 B1 | 12-04-2022 |
| | | JP 2022087171 A | 09-06-2022 |
| | | JP WO2021251288 A1 | 16-12-2021 |
| | | KR 20220044746 A | 11-04-2022 |
| | | MY 195622 A | 02-02-2023 |
| | | TW 202203726 A | 16-01-2022 |
| | | US 2022351906 A1 | 03-11-2022 |

For more details about this annex : see Official Journal of the European Patent Office, No. 12/82

page 1 of 2

## ANNEX TO THE EUROPEAN SEARCH REPORT
## ON EUROPEAN PATENT APPLICATION NO.

EP 23 19 3487

This annex lists the patent family members relating to the patent documents cited in the above-mentioned European search report.
The members are as contained in the European Patent Office EDP file on
The European Patent Office is in no way liable for these particulars which are merely given for the purpose of information.

23-01-2024

| Patent document cited in search report | Publication date | Patent family member(s) | | Publication date |
|---|---|---|---|---|
| | | US | 2023238181 A1 | 27-07-2023 |
| | | WO | 2021251288 A1 | 16-12-2021 |

For more details about this annex : see Official Journal of the European Patent Office, No. 12/82

page 2 of 2

**EP 4 391 735 A1**

**Patent documents cited in the description**

- JP 4161304 B
- JP 4704025 B
- JP 2004244656 A
- JP 2017193778 A